# EUROPEAN PATENT APPLICATION

(11) **EP 2 466 661 A1**
(43) Date of publication of application: **20.06.2012**
(21) Application number: 10196000.3
(22) Date of filing: 20.12.2010
(51) Int. Cl.: H01L 41/08, H01L 41/22

(54) **Piezoelectric structure**

(71) Applicant: Nederlandse Organisatie voor Toegepast -Natuurwetenschappelijk Onderzoek TNO, 2628 VK Delft (NL)
(72) Inventor: van den Ende, Daan Anton, 2628 VK Delft (NL); Groen, Wilhelm Albert, 2628 VK Delft (NL)
(74) Representative: Jansen, Cornelis Marinus

(57) **Abstract**

A method of manufacturing a piezoelectric structure (10), comprising: providing a first set of electrodes (14a) and a second set of electrodes (14b) arranged in an alternating interdigitated pattern, wherein the electrodes are positioned at a predetermined interval (tᵢ) from one another; providing elongate piezoelectric elements (16) having lengths longer than half the predetermined interval and shorter than the predetermined interval; providing a layer, comprising a fluid carrier and the piezoelectric elements, that connects the electrodes; applying an alternating voltage between the first and second set of electrodes so as to create an alternating electric field in the layer that aligns the piezoelectrical elements with the electric field; solidifying the fluid carrier to form a solid matrix material.

## Description

The present invention relates to a piezoelectric structure and a method of manufacturing the same.

WO03095244 A1 discloses the use of piezoelectric structures having long, continuous piezoelectric fibers in an automobile tire vibration energy scavenging application. Such fibers, being able to bear only a relatively low maximum (tensile) strain, are prone to fracturing, especially in fatigue-type applications. The resulting cracks alter the stress state during operation and cause degradation of the output signal over time.

The applicant's co-pending application, PCT/NL2010/050376 filed on 18 June 2010, discloses aligning piezoelectric particles into chains in order to make the piezoelectric structures more robust under strain.

With this background in mind, according to a first aspect, the present invention may provide a method of manufacturing a piezoelectric structure, comprising:
providing a first set of electrodes and a second set of electrodes arranged in an alternating interdigitated pattern, wherein the electrodes are positioned at a predetermined interval from one another;
providing elongate piezoelectric elements having lengths longer than half the predetermined interval and shorter than the predetermined interval;
providing a layer, comprising a fluid carrier and the piezoelectric elements, that connects the electrodes;
applying an alternating voltage between the first and second set of electrodes so as to create an alternating electric field in the layer that aligns the piezoelectrical elements with the electric field;
solidifying the fluid carrier to form a solid matrix material.

According to a second aspect, the present invention may provide a piezoelectric structure, comprising:
providing a first set of electrodes and a second set of electrodes arranged in an alternating interdigitated pattern, wherein the electrodes are positioned at a predetermined interval from one another;
a layer that connects the electrodes and comprises a matrix material and elongate piezoelectric elements that have been aligned such that they extend between the electrodes, wherein the elongate piezoelectric elements have lengths longer than half the predetermined interval and shorter than the predetermined interval.

In accordance with the present invention, when elongate piezoelectric elements are spaced inside a matrix material, a piezoelectric structure results which provides both robustness and flexibility, while allowing the generation of substantial piezoelectric charge. The piezoelectric elements are shorter than the predetermined interval in order to prevent the piezoelectric elements becoming interconnected effectively continuously along the piezoelectric structure which is detrimental to its robustness.

In the context of the present invention, references to the length of the elongate piezoelectric elements are to be understood as referring to their nominal length. A batch of piezoelectric elements manufactured to a certain nominal length have actual lengths that vary within the tolerances of the manufacturing process.

In preferred embodiments, the length of a majority, most or, most preferably, all of the piezoelectric elements are arranged to be such that the opposite ends of an individual piezoelectric element contact the side surfaces of adjacent electrodes.

Preferably, the piezoelectric elements are uniform in cross-section along their length, whereby they provide a reliable and consistent pathway for the generated piezoelectric charge.

Preferably, the piezoelectric elements are stiff, whereby they do not curve in conformity with the electric fields created between the electrodes during manufacture.

Preferably, only a single layer of piezoelectric elements is formed. In other embodiments, more than one layer of piezoelectric elements is formed.

Preferably, the first and second sets of electrodes are provided on a substrate. The substrate may be either permanent or removed as a last manufacturing step.

The electrodes may have a first predetermined spacing between their top surfaces, a second predetermined spacing between their bottom surfaces and a predetermined width at their top surfaces.

In an embodiment, the side surfaces of a said electrode are vertical, i.e. the first and second predetermined spacings are equal. In this embodiment, the length of a majority, most or, most preferably, all of the piezoelectric elements are arranged to be equal to the first/second predetermined spacing, whereby the opposite ends of those piezoelectric elements contact the side surfaces of adjacent electrodes.

In an embodiment, the side surfaces of a said electrode upwardly converge, i.e. the electrode has a trapezoidal cross-section. In this embodiment, the length of a majority, most, or most preferably, all of the piezoelectric elements are arranged to be longer than or equal to the second predetermined spacing and shorter than or equal to the first predetermined spacing, whereby the opposite ends of those piezoelectric elements contact the side surfaces of adjacent electrodes.

In the context of the present invention, terms of orientation such as top, height, vertical, upward, bottom, side and the like are to be construed relative to the substrate which is considered to be at the bottom of the structure and horizontal.

Exemplary embodiments of the present invention are hereinafter described with reference to the accompanying drawings, in which:
Figure 1 shows a plan view of a first piezoelectric structure;
Figure 2 shows a side view of Figure 1;
Figure 3 shows a part of the detail labelled A in Figure 1 (with substrate omitted);
Figure 4 shows a side view of Figure 3 (with substrate depicted);
Figure 5 illustrates the relative strain in the fibers (compared to the continuous fibers case) as a function of gap distance;
Figure 6 illustrates the relative charge output as a function of relative strain in the fibers for different gap lengths between fibers for 2 different matrix materials;
Figures 7(a-c) and Figures 8(a-c) show side views of a part of a second piezoelectric structure; and
Figures 9(a-c) show side views of a part of a third piezoelectric structure.

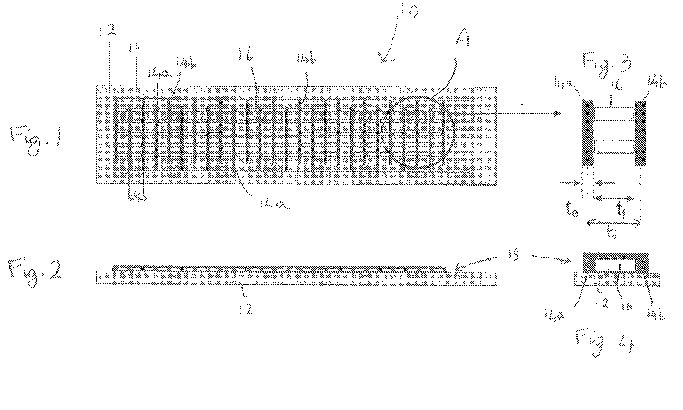

A first piezoelectric structure 10 shown in Figures 1 to 4 is manufactured by the following steps.

Providing a mainly planar substrate 12 having a first set of electrodes 14a and a second set of electrodes 14b arranged in an interdigitated pattern (both more or less comb shaped) that occupy a substantially planar layer. The electrodes are alternating whereby an electrode from one set is neighboured by two from the other set. The electrodes are positioned at intervals of tᵢ from one another, have a width of tₑ, and have a spacing between any neighbouring pair of electrodes of sₑ. The electrodes may be formed by any well-known process like printing, sputtering or using lithographic techniques.

Providing elongate piezoelectric elements comprising short fibers 16. The short fibers 16 are manufactured by spinning and then are chopped to a length t_{f} that is substantially equal to the spacing sₑ between the electrodes 14a,b. The fibers 16 are stiff and uniform in cross-section along their length. In this embodiment, the fibers comprise piezoelectric ceramic fibers, from any piezoelectric ceramic material, such as lead-zirconium-titanate (PZT) based sodium-potassium-niobate (KNN), bismuth-sodium-titanate or barium-titanate based fibers.

Providing a layer or film, comprising a mixture of a fluid carrier and the fibers 16, on the substrate 12 that connects the electrodes 14a,b. In this embodiment, the fluid carrier comprises a thermosetting polymer, i.e. a polymer that starts off liquid and can be solidified, by curing, for example, epoxy. Alternatively, the fluid carrier may comprise polyurethanes or rubbers, including polyurethane rubbers, silicone rubbers, or liquid natural rubber.
These materials can be heat or light-curing. As a further alternative, the fluid carrier may comprise polyimides that are solidified by thermal imidisation. The fluid carrier may be applied to the substrate 12 first and the fibers then added. Alternatively, the fibers may be pre-mixed with the fluid carrier.

Applying an AC voltage between the first and second sets of electrodes 14a,b so as to create an alternating electric fields in the layer. The electric fields pull the fibers 16 down into the region between the electrodes 14a,b and orientate the fibers 16 such that their longitudinal axes become aligned therewith. Due to the matching dimensions sₑ and tₑ, the fibers 16 become pinned or trapped into place between the electrodes 14a,b. The concentration of fibers 16 in the fluid carrier is arranged to be just sufficient to provide a single layer of fibers 16 between the electrodes 14a,b.

Solidifying the fluid carrier by curing to form a solid matrix material 18.

Poling of the fibers by applying a DC voltage between the first and second sets of electrodes 14a,b.

In a variation of the above-described method, instead of using a thermosetting polymer as the fluid carrier, a thermoplastic polymer that must first be dissolved in solvent is used. Suitable examples include poly-vinylidene-fluoride (PVDF) and co-polymers, poly(ethylene terephthalate) PET or poly(ethylene naphtalate) and poly ether ether ketone (PEEK), poly (ether imide) (PEI) and other high performance polymers. In this instance, the solidifying step is performed by evaporating off the solvent, thereby returning the polymer to its solid state with the fibers still in place.

It will be noted from Figure 4 that the fibers form part of a single layer occupying the space between the electrodes, i.e. only matrix material 18 is situated above a given fiber. By changing the width tₑ of the electrodes and the spacing sₑ between the electrodes, the overall gap, in the lengthwise direction of the fibers 16, can be controlled and, therefore, the strain in the fibers 16 can be controlled.

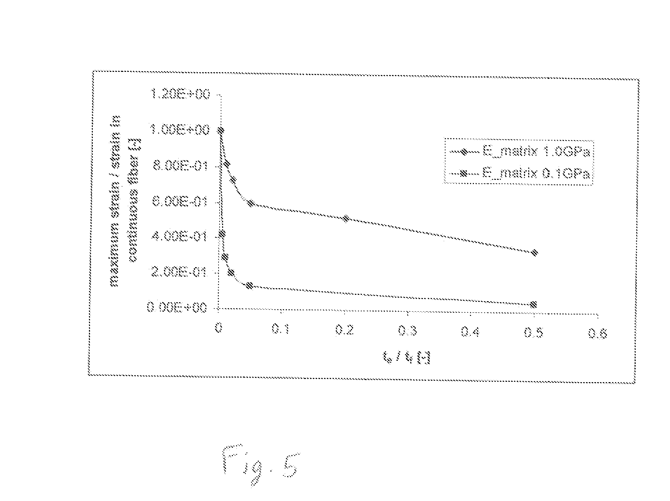

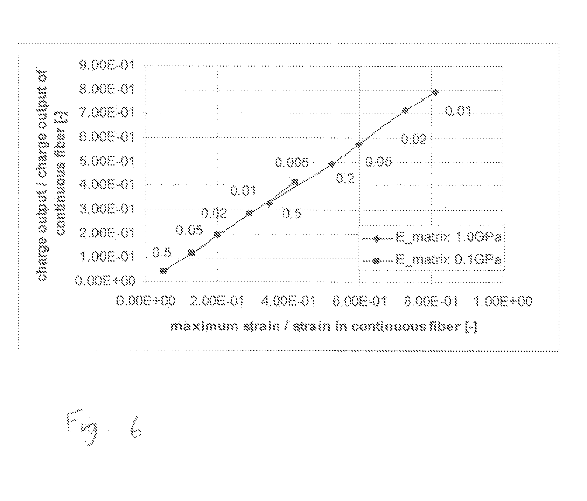

The operational performance of the first piezoelectric structure 10 is now illustrated with reference to Figures 5 and 6.

1mm long PZT (5A grade) is embedded in elastic matrix material with 2 different elastic moduli (1.0GPa and O.lGPa). The fiber length t_{f} is fixed at 0.5mm and the gap (i.e. electrode width tₑ) ranges from 0.01mm to 0.5mm. The applied strain is 0.1%, i.e. a continuous fiber has the full 0.1% strain. The relative strain in the fiber (compared to the continuous case) as a function of gap distance is presented in Figure 5 and the charge output of the short fiber as a function of the relative strain (points correspond to electrode widths) is presented in Figure 6. For this configuration the strain in the fibers can be controlled from about 5-80% of the strain that continuous fibers would experience case for only 2 types of matrix material with very realistic elastic stiffness. This makes the piezoelectric structure around 20x more robust than the structure with continuous fibers. The output scales almost equally with the relative strain. The robustness of the piezoelectric structure can be controlled at the expense of charge output.

In use, the piezoelectric structure 10 is attached to a vibrating or otherwise deforming host structure in such a way that the deformations of the host structure cause the piezoelectric structure 10 to be strained. When strained, the fibers 16 in the structure generate electrical charge which is collected by the electrodes 14a,b and can be used as electrical energy for powering electronics or stored in a capacitor or battery for later use. It will be noted that the same electrodes 14a,b serve the dual role of both applying the electric field to align the fibers 16 during manufacture and extracting the charge that is generated by the fibers 16 when the structure is deformed in normal operational use.

This type of piezoelectric structure may be very useful in environments where high strain/vibration energy is abundant (aircraft/space/wind/underwater (deep sea) structures, automobile tires), for local powering of sensors and electronics with increased reliability.

Thus, it will be appreciated that by altering the matrix material stiffness and gap spacing (i.e. electrode width tₑ) between fibers, the maximum strain can be controlled. By controlling the electrode width, the gap between the fibers can be controlled and therefore the robustness of the device can be adjusted to the needs of the application.

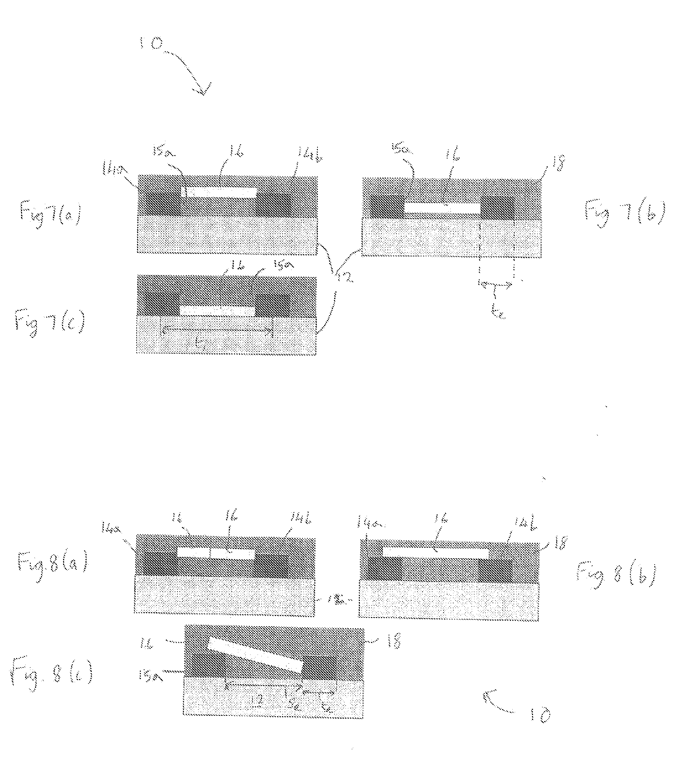

A second piezoelectric structure 10 is shown in Figures 7(a-c) and Figures 8(a-c). All that was disclosed in relation to the first piezoelectric structure 10 applies mutatis mutandis to the second piezoelectric structure, the second piezoelectric structure differing from the first piezoelectric structure only in the height of the electrodes. In the first piezoelectric structure, the electrodes are of a small or negligible height relative to the depth of the fibers as is plainly visible in Figure 4. In the second piezoelectric structure 10, the height of the electrodes is larger than the depth of the fibers.

Figures 7(a-c) show the preferred interaction between the fibers 16 and the electrodes 14a,b. For fibers 16 having a length t_{f} equal to the electrode spacing sₑ, the fibers 16 become pinned between vertical side surfaces 15a of the electrodes 14a,b, and thereby provide a continuous connection therebetween which is of great benefit to the level of the output signal. Figures 8(a-c) show some less preferred possible interactions between the fibers 16 and the electrodes 14a,b for fibers that have a length t_{f} that is not equal to the electrode spacing sₑ. The Figure 8(a) interaction is not preferred since the connected fibers form an imperfect electrical interface between one another.

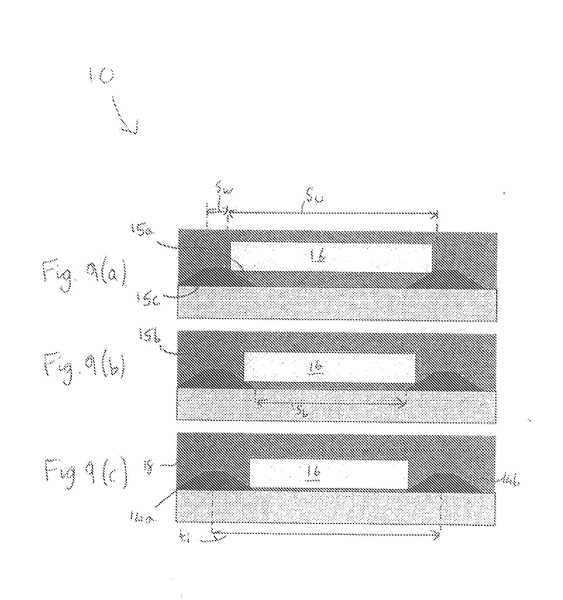

A third piezoelectric structure 10 is shown in Figures 9(a-c). All that was disclosed in relation to the first and second piezoelectric structures 10 applies mutatis mutandis to the third piezoelectric structure, the third piezoelectric structure differing from the second piezoelectric structure only in the shape of the electrodes.

The electrodes 14a,b are trapezoidal in cross-section, are positioned at intervals of tᵢ from one another, and have a spacing sᵤ between their top surfaces 15b, a spacing s_{b} between their bottom surfaces 15c and a width at their top surfaces 15b of s_{w}. The slopes of the side surfaces 15a allow fibers 16 of different lengths to be pinned between the electrodes. This is useful in cases where either chopped fibers having a large tolerance specification (which are hence cheaper to produce) or where mixtures of different fibers having a different nominal length are intentionally used. Although this embodiment may be cheaper to produce, it tends to provide a less quality solution since it leads to the different fibers being subjected to a range of relative strains.

The above-described piezoelectric structures differ from those disclosed in the applicant's above-mentioned co-pending application in several respects.

First, although the particles disclosed in the co-pending application are brought into good alignment, the alignment may nonetheless be imperfect. Such imperfection may tend to arise due to the inherent shape of the particles and/or their irregular surface roughness. As a result, any two adjacent particles in a chain may only be in contact over only a limited surface area to the detriment of the output signal. In contrast, in the above-described embodiments, the use of fibers introduces no such imperfections, since the fibers are of substantially uniform cross-section along their length. In the case of the most preferred embodiments in which a majority of the fibers have a length that enables them to be pinned between the side surfaces of adjacent electrodes, a continuous connection between the piezoelectric fibers and the electrodes may be achieved which is of great benefit to the level of the output signal.

Second, there is no need for any step equivalent to the particle chains being pulled downwardly (either by an external field or by gravity). The particle chains, though connected, are still relatively flexible and may curve to conform with the exact path of the electric field between the electrodes; the electric field tends to arch over the space between the electrode, so an extra step is needed to pull them downwardly towards the bottom. In contrast, the fibers of the above-described embodiments being relatively stiff cannot conform to this arching shape and will be pulled downwardly automatically.

Third, the particle chains do not constitute elongate piezoelectric elements within the meaning of the present invention. The particles are made to arrange themselves as a chain when inside the carrier fluid and are held in this arrangement by the solidified matrix material. However, this geometry is not intrinsic to the particles chains themselves, since, if the matrix material was somehow removed, the chains would easily disintegrate into a powder. On the other hand, the fibers 16 used in the preferred embodiments of the present invention are intrinsically elongate and would remain so even if the matrix material was somehow removed.

In accordance with preferred embodiments of the present invention, fiber sizes are preferably up to 1mm in length and 300µm in the lateral dimension.

In other embodiments, instead of fibers, other elongate piezoelectric elements may be used; such elements may be obtained in other ways such as growing of strands ("bottom-up synthesis") or various other chemical techniques.

The applicant hereby discloses in isolation each individual feature described herein and any combination of two or more such features, to the extent that such features or combinations are capable of being carried out based on the present specification as a whole in the light of the common general knowledge of a person skilled in the art, irrespective of whether such features or combinations of features solve any problems disclosed herein, and without limitation to the scope of the claims. The applicant indicates that aspects of the present invention may consist of any such individual feature or combination of features. In view of the foregoing description it will be evident to a person skilled in the art that various modifications may be made within the scope of the invention.

## Claims

1. A method of manufacturing a piezoelectric structure, comprising:
providing a first set of electrodes and a second set of electrodes arranged in an alternating interdigitated pattern, wherein the electrodes are positioned at a predetermined interval from one another;
providing elongate piezoelectric elements having lengths longer than half the predetermined interval and shorter than the predetermined interval;
providing a layer, comprising a fluid carrier and the piezoelectric elements, that connects the electrodes;
applying an alternating voltage between the first and second set of electrodes so as to create an alternating electric field in the layer that aligns the piezoelectrical elements with the electric field;
solidifying the fluid carrier to form a solid matrix material.

2. A method as in claim 1, wherein the lengths of a majority of the piezoelectric elements are arranged to be such that the opposite ends of an individual piezoelectric element contact the side surfaces of adjacent electrodes.

3. A method as in claims 1 or 2, wherein the piezoelectric elements are uniform in cross-section along their length.

4. A method as in any preceding claim, wherein the piezoelectric elements are stiff.

5. A method as in any preceding claim, wherein a single layer of piezoelectric elements is formed.

6. A method as in any preceding claim, wherein the electrodes have a first predetermined spacing between their top surfaces, a second spacing between their bottom surfaces and a predetermined width at their top surfaces.

7. A method as in claim 6, wherein the side surfaces of a said electrode are vertical and the lengths of a majority of the piezoelectric elements are arranged to be equal to the first/second predetermined spacing.

8. A method as in claim 6, wherein the side surfaces of a said electrode vertically converge and the lengths of a majority of the piezoelectric elements are arranged to be longer than or equal to the second predetermined spacing and shorter than or equal to the first predetermined spacing.

9. A method as in any preceding claim, wherein the fluid carrier comprises a thermosetting polymer that is solidified into a matrix material by curing.

10. A method as in any of claims 1 to 8, wherein the fluid carrier is a thermoplastic polymer dissolved in a solvent that is solidified into a matrix material by evaporating the solvent.

11. A method as in any preceding claim, wherein the first and second sets of electrodes are provided on a substrate.

12. A method as in any preceding claim, further comprising applying a DC voltage between the first and second set of electrodes so as to the effect poling of the piezoelectric elements.

13. A piezoelectric structure, comprising:
providing a first set of electrodes and a second set of electrodes arranged in an alternating interdigitated pattern, wherein the electrodes are positioned at a predetermined interval from one another;
a layer that connects the electrodes and comprises a matrix material and elongate piezoelectric elements that have been aligned such that they extend between the electrodes, wherein the elongate piezoelectric elements have lengths longer than half the predetermined interval and shorter than the predetermined interval.

14. A piezoelectric structure as in claim 13, wherein the piezoelectric elements comprise fibers.

15. A piezoelectric structure as in claims 13 or 14, wherein the piezoelectric elements comprise chopped ceramic fibers.
